# EUROPEAN PATENT APPLICATION

(11) **EP 3 392 993 A1**
(43) Date of publication of application: **24.10.2018**
(21) Application number: 17167153.0
(22) Date of filing: 19.04.2017
(51) Int. Cl.: H02H 9/04, H02H 1/00

(54) **ELECTROSTATIC DISCHARGE PROTECTION CIRCUIT AND DEVICE**

(71) Applicant: Vestel Elektronik Sanayi ve Ticaret A.S., 45030 Manisa (TR)
(72) Inventor: ÖZBAY, Mustafa Caner, 45030 Manisa (TR); DERELI, Ulas, 45030 Manisa (TR)
(74) Representative: Flint, Adam

(57) **Abstract**

An electrostatic discharge protection circuit (16) protects a device (10) from electrostatic discharge. The circuit (16) has a hardware controller (18) which is operable to output a restart signal to the device (10). The circuit (16) has a hardware comparator (20). The hardware comparator (20) has an output connected to the hardware controller (18). The hardware comparator (20) has a first input (IN1) for connection to a clear ground (22), and a second input (IN2) for connection to a portion (24) of the device (10) that is susceptible to electrostatic discharge. A reset signal is produced at the output of the hardware comparator (20) if a difference between the voltage at the first input (IN1) and a voltage at the second input (IN2) exceeds a threshold. The reset signal is at the hardware controller (18), which causes the hardware controller (18) to output a restart signal to the device (10).

## Description

### Technical Field

The present disclosure relates to an electrostatic discharge protection circuit and a device having an electrostatic discharge protection circuit.

### Background

Electrostatic discharge is a recurrent and common problem for devices, especially electronic devices. Static electricity can easily accumulate on a person (such as on the person's clothing) and on other objects. If a device, such as an electronic device, comes close to or in contact with the build-up of static electricity, an electrostatic discharge to the device can occur, which can damage the device, possibly catastrophically.

### Summary

According to a first aspect disclosed herein, there is provided an electrostatic discharge protection circuit for protecting a device from electrostatic discharge, the circuit comprising:
a hardware controller for connection to a device which is to be protected from electrostatic discharge, the hardware controller being constructed and arranged to output a restart signal to a device connected to the hardware controller; and
a hardware comparator, the hardware comparator having an output connected to an input of the hardware controller, a first input for connection to a clear ground, and a second input for connection to a portion of a device connected to the hardware controller that is susceptible to electrostatic discharge;
the arrangement being such that a reset signal is produced at the output of the hardware comparator if a difference between a voltage at the first input of the hardware comparator and a voltage at the second input of the hardware comparator exceeds a threshold, the reset signal being received at the input of the hardware controller and causing the hardware controller to output a restart signal to a device connected to the hardware controller.

Examples of embodiments provide protection from static electricity discharge for a device. Implementing the controller and the comparator in hardware means that the circuit operates much faster than an equivalent controller that is implemented in software for example.

In an example, the threshold for the difference is zero. Other, typically small, values for the threshold may be used.

In an example, the hardware controller is an integrated circuit. The hardware controller may be for example a microcontroller, an ASIC (application-specific integrated circuit) or a FPGA (field programmable gate array).

In an example, the comparator is an op-amp or a comparator integrated circuit.

According to a second aspect disclosed herein, there is provided an electronic device, the device comprising:
at least one processor for controlling the device; and
an electrostatic discharge protection circuit for protecting the device from electrostatic discharge, the circuit comprising:
   a hardware controller constructed and arranged to output a restart signal to the device processor; and
   a hardware comparator, the hardware comparator having an output connected to an input of the hardware controller, a first input for connection to a clear ground, and a second input electrically connected to a portion of the device that is susceptible to electrostatic discharge;
   the arrangement being such that a reset signal is produced at the output of the hardware comparator if a difference between a voltage at the first input of the hardware comparator and a voltage at the second input of the hardware comparator exceeds a threshold, the reset signal being received at the input of the hardware controller and causing the hardware controller to output a restart signal to the device processor to cause the device to restart.

According to a third aspect disclosed herein, there is provided a method of controlling an electronic device, the method comprising:
receiving at a first input of a hardware comparator a voltage from a clear ground;
receiving at a second input of a hardware comparator a voltage from a portion of the device that is susceptible to electrostatic discharge;
producing a reset signal at an output of the hardware comparator if a difference between the voltage at the first input of the hardware comparator and the voltage at the second input of the hardware comparator exceeds a threshold;
receiving the reset signal at an input of a hardware controller; and
in response to receiving the reset signal, the hardware controller outputting a restart signal to the device to cause the device to restart.

### Brief Description of the Drawings

To assist understanding of the present disclosure and to show how embodiments may be put into effect, reference is made by way of example to the accompanying drawings in which:
Figure 1 shows schematically an example of an electronic device having an electrostatic discharge protection circuit; and
Figure 2 shows schematically an example of a method of operation of an electrostatic discharge protection circuit.

### Detailed Description

As mentioned, if a device, such as an electronic device, comes close to or in contact with a build-up of static electricity, an electrostatic discharge to the device can occur, which can damage the device, possibly catastrophically, or at least can cause the device to "freeze" or "crash" (for example the operating system of the device ceases to operate and hangs).

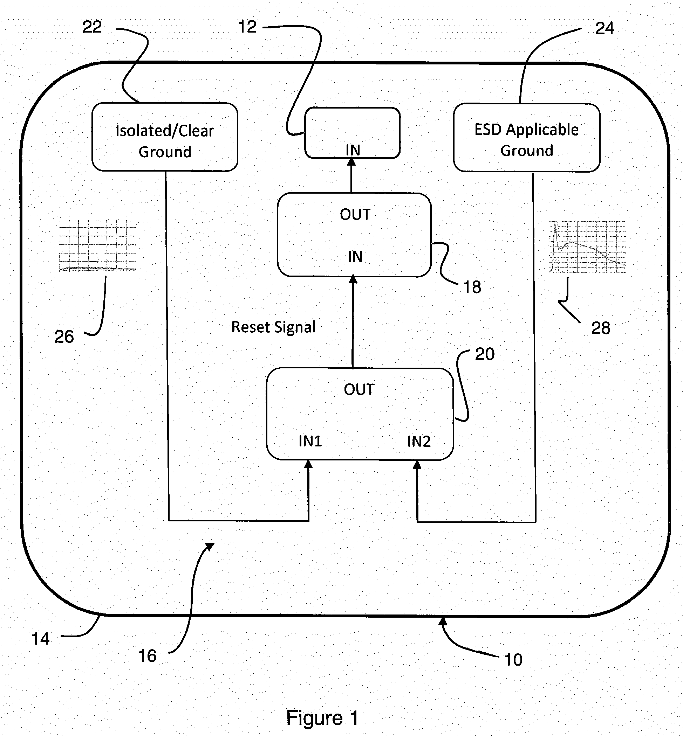

Referring to Figure 1, there is shown schematically an example of an electronic device 10. The device 10 may in general be any electronic device, including for example a smartphone, a desktop or laptop computer, a tablet computer, a television, a DVD or other media player, a set-top box, a gaming console, etc., etc. The device 10 has at least one processor 12. The processor 12 may be a "main" processor or CPU (central processing unit) of the device 10 or some other processor that is able to restart the device 10 as described further below. The device 10 has a main outer housing 14.

The device 10 includes an electrostatic discharge protection circuit 16. The electrostatic discharge protection circuit 16 may be built into the device 10, for example located within the main outer housing 14, or may be provided as a separate unit which can be electrically connected to the device 10 (specifically, electrically connected to the processor 12 of the device 10).

The electrostatic discharge protection circuit 16 includes a controller 18. The controller 18 is a hardware controller 18, that is, a controller that is implemented in hardware. A controller that is implemented in hardware operates much faster than an equivalent controller that is implemented in software for example. The hardware controller 18 may be provided as a single chip or integrated circuit. The hardware controller 18 may be for example a microcontroller, that is a CPU with memory and input(s) and output(s), which may also be referred to as a system-on-a-chip or SOC. As another example, the hardware controller 18 may be implemented by an ASIC (application-specific integrated circuit). As another example, the hardware controller 18 may be implemented by an FPGA (field programmable gate array). The hardware controller 18 has an output OUT which is electrically connected to an input IN of the processor 12 of the device 10. In some examples, the controller 18 has overall control of operation of the device 10, including of the processor 12 of the device 10, and therefore has overall control of every process running on the device 10.

The electrostatic discharge protection circuit 16 also includes a comparator 20. The comparator 20 is a hardware comparator 20, that is, a comparator that is implemented in hardware. A comparator that is implemented in hardware operates much faster than an equivalent comparator that is implemented in software for example. The hardware comparator 20 may be for example an op-amp voltage comparator. As another example, the hardware comparator 20 may be a comparator integrated circuit.

The hardware comparator 20 has an output OUT which is electrically connected to an input IN of the hardware controller 18. The hardware comparator 20 has two inputs IN1, IN2. Voltages that are presented at the inputs IN1, IN2 of the hardware comparator 20 are compared and an output signal presented at the output OUT of the hardware comparator 20 if the difference between the voltages exceeds some threshold. The threshold may be zero or some other (typically small) value. As will be discussed further below, the output signal presented at the output OUT of the hardware comparator 20 may be a reset signal which causes the controller 18 to send a restart signal to the input IN of the processor 12 of the device 10, which, in turn, causes the device 10 to restart.

One input IN1 of the comparator 20 is electrically connected to some isolated or clear ground (or earth) 22. That is, the input IN1 of the comparator 20 is electrically connected to a ground 22 that is known will not be affected by an electrostatic discharge to the device 10, or at least is unlikely to be affected. For example, for a device 10 that is powered by a mains electricity supply, the input IN1 of the comparator 20 may be electrically connected to an earth of the mains electricity supply. As another example, there may be a portion of the device 10 that can be regarded as being electrically connected to a clear ground, such as a metal casing or the like of the device 10 which is normally in contact with an earth (such as a building floor or a shelf or other support that is electrically connected to earth). The input IN1 may be connected to the clear ground 22 via a series resistor.

The other input IN2 of the comparator 20 is electrically connected to at least one portion 24 of the device 10 that is susceptible to electrostatic discharge. The other input IN2 of the comparator 20 may be electrically connected to several portions 24 of the device 10 that are susceptible to electrostatic discharge. As a specific example, a television set typically has a number of ports or connectors, such as for HDMI (High-Definition Multimedia Interface) cables, audio cables, USB (Universal Serial Bus), etc. These may have a grounded shield. This means that if a user attempts to plug in a cable and the user has an accumulated static charge, the accumulated static charge can flow to that ground, potentially damaging the television set. The input IN2 may be connected to the portion(s) 24 of the device 10 that is/are susceptible to electrostatic discharge via a series resistor(s).

Normally, when there is no electrostatic discharge, there is no voltage difference between these two inputs IN1, IN2 and the comparator 20 does not output any control or rest signal. If however static electricity flows to the portion 24 of the device 10 that is susceptible to electrostatic discharge and to which the second input pin IN2 of the comparator 20 is connected, there will be a voltage difference between the two inputs IN1, IN2 pin and the comparator 20 outputs a control or reset signal. The output control or reset signal of the comparator 20 is passed to the input IN of the controller 18, which in turn sends a restart signal to the input IN of the processor 12 of the device 10, which, in turn, causes the device 10 to restart.

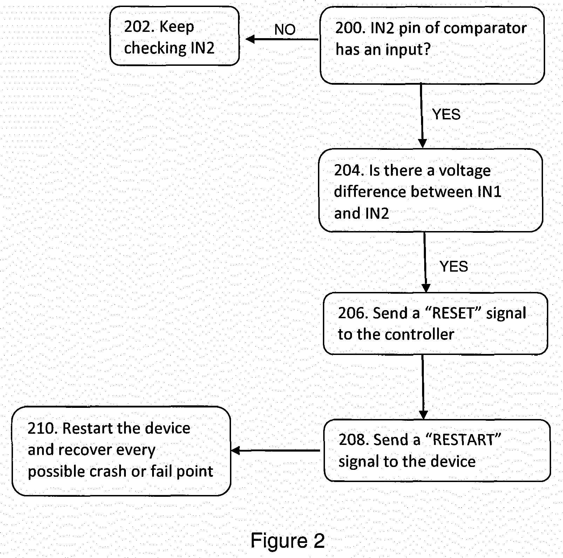

The voltages that are presented at the inputs IN1, IN2 of the comparator 20 are indicated by graphs 26, 28 respectively of voltage against time in Figure 2. As shown by the first graph 26, the voltage of the clear ground 22, which is presented at the first input IN1, is in substance zero at all times. On the other hand, the voltage of the portion 24 of the device 10 that is susceptible to electrostatic discharge, which is presented to the second input IN2, is shown as rising rapidly because static electricity has discharged to that portion 24. The voltage decays over time as the charge is dissipated.

An example of a method is shown schematically in Figure 2. At 200, it is checked whether the second input pin IN2 of the comparator 20 has an input. If no, then at 202 the check for whether the second input pin IN2 of the comparator 20 has an input is continued. If yes, then at 204 the voltages at the first and second input pins IN1, IN2 of the comparator 20 are compared. If there is a voltage difference (or at least a voltage difference above some threshold) at the first and second input pins IN1, IN2 of the comparator 20, then a RESET signal is sent to the controller 18. At 208, the controller 18 sends a RESTART signal to the device 10. At 210, the device 10 is restarted. Optionally, the device 10 also attempts to recover the crash or fail point.

It will be understood that the processor or processing system or circuitry referred to herein, including in particular the hardware controller, may in practice be provided by a single chip or integrated circuit or plural chips or integrated circuits, optionally provided as a chipset, an application-specific integrated circuit (ASIC), field-programmable gate array (FPGA), etc.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. An electrostatic discharge protection circuit for protecting a device from electrostatic discharge, the circuit comprising:
a hardware controller for connection to a device which is to be protected from electrostatic discharge, the hardware controller being constructed and arranged to output a restart signal to a device connected to the hardware controller; and
a hardware comparator, the hardware comparator having an output connected to an input of the hardware controller, a first input for connection to a clear ground, and a second input for connection to a portion of a device connected to the hardware controller that is susceptible to electrostatic discharge;
the arrangement being such that a reset signal is produced at the output of the hardware comparator if a difference between a voltage at the first input of the hardware comparator and a voltage at the second input of the hardware comparator exceeds a threshold, the reset signal being received at the input of the hardware controller and causing the hardware controller to output a restart signal to a device connected to the hardware controller.

2. An electrostatic discharge protection circuit according to claim 1, wherein the threshold for the difference is zero.

3. An electrostatic discharge protection circuit according to claim 1 or claim 2, wherein the hardware controller is an integrated circuit.

4. An electrostatic discharge protection circuit according to any of claims 1 to 3, wherein the comparator is an op-amp or a comparator integrated circuit.

5. An electronic device, the device comprising:
at least one processor for controlling the device; and
an electrostatic discharge protection circuit for protecting the device from electrostatic discharge, the circuit comprising:
a hardware controller constructed and arranged to output a restart signal to the device processor; and
a hardware comparator, the hardware comparator having an output connected to an input of the hardware controller, a first input for connection to a clear ground, and a second input electrically connected to a portion of the device that is susceptible to electrostatic discharge;
the arrangement being such that a reset signal is produced at the output of the hardware comparator if a difference between a voltage at the first input of the hardware comparator and a voltage at the second input of the hardware comparator exceeds a threshold, the reset signal being received at the input of the hardware controller and causing the hardware controller to output a restart signal to the device processor to cause the device to restart.

6. A device according to claim 5, wherein the threshold for the difference is zero.

7. A device according to claim 5 or claim 6, wherein the hardware controller is an integrated circuit.

8. A device according to any of claims 5 to 7, wherein the comparator is an op-amp or a comparator integrated circuit.

9. A method of controlling an electronic device, the method comprising:
receiving at a first input of a hardware comparator a voltage from a clear ground;
receiving at a second input of a hardware comparator a voltage from a portion of the device that is susceptible to electrostatic discharge;
producing a reset signal at an output of the hardware comparator if a difference between the voltage at the first input of the hardware comparator and the voltage at the second input of the hardware comparator exceeds a threshold;
receiving the reset signal at an input of a hardware controller; and
in response to receiving the reset signal, the hardware controller outputting a restart signal to the device to cause the device to restart.

10. A method according to claim 9, wherein the threshold for the difference is zero.

11. A method according to claim 9 or claim 10, wherein the hardware controller is an integrated circuit.

12. A method according to any of claims 9 to 11, wherein the comparator is an op-amp or a comparator integrated circuit.
